(19) Europäisches Patentamt / European Patent Office / Office européen des brevets

(11) **EP 4 184 183 B1**

(12) **FASCICULE DE BREVET EUROPEEN**

(45) Date de publication et mention
de la délivrance du brevet:
**27.03.2024 Bulletin 2024/13**

(21) Numéro de dépôt: **22207560.8**

(22) Date de dépôt: **15.11.2022**

(51) Classification Internationale des Brevets (IPC):
***G01R 22/06*** *(2006.01)*

(52) Classification Coopérative des Brevets (CPC):
**G01R 22/068**

(54) **DETECTION DE L'ETAT OUVERT OU FERME D'UN DISJONCTEUR**

ERKENNUNG DES OFFENEN ODER GESCHLOSSENEN ZUSTANDES EINES LEISTUNGSSCHALTERS

DETECTION OF OPEN OR CLOSED STATE OF A CIRCUIT BREAKER

(84) Etats contractants désignés:
AL AT BE BG CH CY CZ DE DK EE ES FI FR GB GR HR HU IE IS IT LI LT LU LV MC ME MK MT NL NO PL PT RO RS SE SI SK SM TR

(30) Priorité: **22.11.2021 FR 2112312**

(43) Date de publication de la demande:
**24.05.2023 Bulletin 2023/21**

(73) Titulaire: **Sagemcom Energy & Telecom SAS**
**92270 Bois-Colombes (FR)**

(72) Inventeurs:
• **TEBOULLE, Henri**
**92500 RUEIL MALMAISON (FR)**
• **LHUILLIER, Pierre**
**92500 RUEIL MALMAISON (FR)**

(74) Mandataire: **Cabinet Boettcher**
**5, rue de Vienne**
**75008 Paris (FR)**

(56) Documents cités:
**US-A1- 2020 309 856    US-B2- 8 610 424**

**Description**

L'invention concerne le domaine des compteurs électriques.

ARRIERE PLAN DE L'INVENTION

Les compteurs électriques modernes sont des compteurs électroniques dits « intelligents » qui sont bien sûr conçus pour mesurer une énergie électrique fournie par un distributeur à une installation électrique via un réseau de distribution, mais qui sont aussi capables de réaliser un certain nombre de fonctions complémentaires : gestion des tarifs par réception d'ordres, relève et programmation à distance, télé-information client, etc.

Certains compteurs électriques comportent un organe de coupure (situé à l'intérieur du compteur électrique), qui permet de sélectivement connecter et déconnecter, à distance ou depuis le compteur électrique, l'installation électrique du réseau de distribution. L'organe de coupure est notamment utilisé pour couper ou rétablir à distance l'alimentation de l'installation en cas, par exemple, de résiliation de l'abonnement ou de non-respect du contrat d'abonnement.

Les installations électriques sont par ailleurs fréquemment équipées d'un disjoncteur, situé à l'extérieur et en aval du compteur électrique (c'est-à-dire du côté de l'installation). Le disjoncteur, qui peut être actionné par l'abonné, a notamment pour rôle de protéger l'installation en s'ouvrant lorsqu'une surtension, résultant par exemple d'un court-circuit entre une phase et le neutre, survient sur le réseau de distribution.

Dans certains pays, suite à une ouverture de l'organe de coupure, on demande aux abonnés d'ouvrir puis de refermer le disjoncteur avant de refermer l'organe de coupure.

Il est alors intéressant, pour rétablir automatiquement la fourniture d'électricité chez l'abonné, que le compteur soit capable, lorsque l'organe de coupure est ouvert, de détecter si le disjoncteur est ouvert ou fermé.

Pour réaliser cette détection, il a été envisagé d'amener en aval de l'organe de coupure une partie de la tension présente sur le réseau, et de « zoomer » sur la tension résultante grâce à un diviseur de tension paramétrable, pour mesurer précisément l'impédance présente en aval du compteur. Ce système permet de différencier un disjoncteur ouvert d'un disjoncteur fermé (et notamment d'un disjoncteur fermé avec une très faible charge et donc une impédance élevée). Ce système de détection est donc relativement efficace, mais nécessite de mesurer un très faible niveau de tension (quelques mV) pour différencier les cas disjoncteur ouvert et disjoncteur fermé. Ce système de détection est donc relativement sensible au bruit.

US 2020/309856 A1 et US 8 610 424 B2 sont des documents pertinents pour l'état de la technique.

OBJET DE L'INVENTION

L'invention a pour objet de détecter depuis l'intérieur du compteur, de manière fiable et robuste, l'état ouvert ou fermé du disjoncteur alors que l'organe de coupure du compteur est ouvert.

RESUME DE L'INVENTION

En vue de la réalisation de ce but, on propose un compteur agencé pour mesurer une énergie électrique fournie à une installation par un réseau de distribution comprenant une phase et un neutre, le compteur étant agencé pour être connecté à un disjoncteur situé à l'extérieur et en aval du compteur, le compteur comportant :

- un conducteur de phase et un conducteur de neutre agencés pour être reliés respectivement à la phase et au neutre du réseau de distribution ;
- un organe de coupure monté sur le conducteur de phase ;
- un circuit de détection comportant :

  ◦ une chaîne d'injection comprenant au moins un composant générateur et un composant d'injection, le au moins un composant générateur étant agencé pour, lorsque l'organe de coupure est ouvert, générer un signal de test avec un niveau de tension prédéterminé, le composant d'injection étant agencé pour injecter le signal de test sur le conducteur de phase en aval de l'organe de coupure ;
  ◦ une chaîne de mesure agencée pour mesurer, en un point de mesure de la chaîne d'injection situé entre le au moins un composant générateur et le composant d'injection, un niveau de tension intermédiaire du signal de test ;
  ◦ un composant de traitement agencé pour déterminer, en fonction du niveau de tension intermédiaire, si le disjoncteur est ouvert ou fermé.

Le circuit de détection du compteur selon l'invention permet donc de détecter, en injectant un signal de test sur le conducteur de phase, si le disjoncteur est ouvert ou fermé lorsque l'organe de coupure est ouvert.

La différence du niveau de tension intermédiaire, entre les cas disjoncteur ouvert et disjoncteur fermé, est typiquement de l'ordre du V ou de la centaine de mV, et est donc facilement mesurable. La détection est moins sensible au bruit et donc plus fiable et plus robuste que dans l'art antérieur.

On propose de plus un compteur tel que précédemment décrit, le composant d'injection étant un premier condensateur intégré dans un premier filtre passe-haut permettant de filtrer des signaux parasites provenant du réseau de distribution.

On propose de plus un compteur tel que précédemment décrit, dans lequel le au moins un composant générateur comporte un module générateur agencé pour produire le signal de test avec le niveau de tension prédéterminé, et un *driver* formant une source de courant agencée pour assurer que le signal de test est généré avec un niveau de courant suffisant pour conserver, en sortie du au moins un composant générateur, un niveau de tension égal au niveau de tension prédéterminé.

On propose de plus un compteur tel que précédemment décrit, dans lequel la chaîne de mesure comporte successivement, d'amont en aval, un deuxième filtre passe-haut, un détecteur d'enveloppe et un filtre passe-bas.

On propose de plus un compteur tel que précédemment décrit, comprenant en outre un convertisseur analogique numérique positionné en amont du détecteur d'enveloppe.

On propose de plus un compteur tel que précédemment décrit, comprenant en outre un convertisseur analogique numérique positionné en aval du détecteur d'enveloppe.

On propose de plus un compteur tel que précédemment décrit, la chaîne d'injection étant agencée pour, lorsque l'organe de coupure est ouvert, injecter le signal de test périodiquement, pendant une durée prédéterminée.

On propose de plus un compteur tel que précédemment décrit, la chaîne d'injection étant agencée pour, lorsque l'organe de coupure est ouvert, injecter le signal de test en continu.

On propose de plus un compteur tel que précédemment décrit, dans lequel le signal de test est un signal alternatif ayant une fréquence au moins cent fois supérieure à une fréquence d'un courant de phase circulant sur la phase du réseau de distribution.

On propose de plus un compteur tel que précédemment décrit, le compteur étant un compteur monophasé.

On propose de plus un compteur tel que précédemment décrit, dans lequel le conducteur de phase est relié à une masse électrique du compteur en amont de l'organe de coupure, le compteur comprenant en outre un deuxième condensateur positionné en amont de l'organe de coupure et ayant une première borne connectée au conducteur de neutre et une deuxième borne connectée au conducteur de phase.

On propose de plus un compteur tel que précédemment décrit, le composant d'injection étant un premier condensateur, la chaîne d'injection comprenant une résistance montée entre le premier condensateur et une sortie du au moins un composant générateur, le composant de traitement étant agencé pour comparer le niveau de tension intermédiaire du signal de test avec un seuil de détection prédéterminé, et pour détecter que le disjoncteur est ouvert lorsque le niveau de tension intermédiaire du signal de test est supérieur au seuil de détection prédéterminé, et que le disjoncteur est fermé lorsque le niveau de tension intermédiaire du signal de test est inférieur ou égal au seuil de détection prédéterminé, le seuil de détection prédéterminé étant compris entre un niveau haut et un niveau bas Vb tel que :

$$Vb = Vp*(Z(C1)+Z(abonné)+Z(C2)//Z(amont))/(R+Z(C1)+Z(abonné)+ Z(C2)//Z(amont)),$$

où :
Vp est le niveau de tension prédéterminé, Z(C1) est une impédance du premier condensateur, Z(C2) est une impédance du deuxième condensateur, Z(amont) est une impédance entre la phase et le neutre en amont du compteur, Z(abonné) est une impédance entre la phase et le neutre en aval du compteur, lesdites impédances étant estimées à une fréquence du signal de test.

On propose de plus un compteur tel que précédemment décrit, le compteur étant un compteur triphasé.

On propose de plus un compteur tel que précédemment décrit, le composant d'injection étant un premier condensateur, la chaîne d'injection comprenant une résistance montée entre le premier condensateur et une sortie du au moins un composant générateur, le composant de traitement étant agencé pour comparer le niveau de tension intermédiaire du signal de test avec un seuil de détection prédéterminé, et pour détecter que le disjoncteur est ouvert lorsque le niveau de tension intermédiaire du signal de test est supérieur au seuil de détection prédéterminé, et que le disjoncteur est fermé lorsque le niveau de tension intermédiaire du signal de test est inférieur ou égal au seuil de détection prédéterminé, le seuil de détection prédéterminé étant compris entre un niveau haut et un niveau bas Vb tel que :

$$Vb = Vp*(Z(C1)+Z(abonné))/(R+Z(C1)+Z(abonné))$$

où :

Vp est le niveau de tension prédéterminé du signal de test, Z(C1) est une impédance du premier condensateur, Z(abonné) est une impédance entre la phase et le neutre en aval du compteur, lesdites impédances étant estimées à une fréquence du signal de test.

On propose de plus un procédé de détection, mis en oeuvre dans le composant de traitement d'un compteur tel que précédemment décrit, et comprenant les étapes, lorsque l'organe de coupure est ouvert, de :

- faire générer et injecter, par la chaîne d'injection, le signal de test sur le conducteur de phase en aval de l'organe de coupure ;
- acquérir le niveau de tension intermédiaire du signal de test ;
- déterminer, en fonction du niveau de tension intermédiaire du signal de test, si le disjoncteur est ouvert ou fermé.

On propose de plus un programme d'ordinateur comprenant des instructions qui conduisent le composant de traitement du compteur tel que précédemment décrit à exécuter les étapes du procédé de détection tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente un compteur électrique selon un premier mode de réalisation de l'invention, le compteur étant un compteur monophasé ;

[Fig. 2] la figure 2 représente un compteur électrique selon un deuxième mode de réalisation de l'invention, le compteur étant un compteur triphasé.

DESCRIPTION DETAILLEE DE L'INVENTION

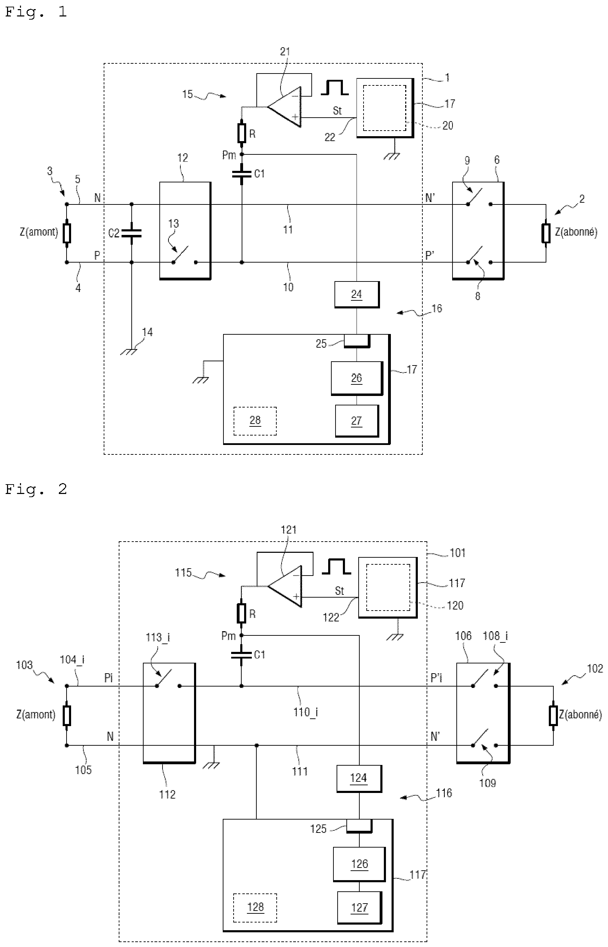

En référence à la figure 1, le compteur 1 selon un premier mode de réalisation de l'invention est un compteur monophasé, qui est destiné à mesurer une énergie électrique fournie à l'installation électrique 2 d'un abonné par un réseau de distribution 3.

Le réseau de distribution 3 comprend une phase 4 et un neutre 5.

Un disjoncteur 6 est situé à l'extérieur et en aval du compteur 1. Ici, lorsque l'on parle de la position relative des différents éléments par rapport à l'installation 2 et au réseau 3, on entend :

- par « en amont » : du côté du réseau 3 ;
- par « en aval » : du côté de l'installation 2.

Le disjoncteur 6 est positionné entre le compteur 1 et l'installation 2.

Le compteur 1 comprend un port de phase amont P relié à la phase 4 et un port de neutre amont N relié au neutre 5. Le compteur 1 comporte de plus un port de phase aval P' et un port de neutre aval N'.

Le port de phase aval P' et le port de neutre aval N' du compteur 1 sont reliés à l'installation 2 respectivement via un interrupteur 8 et un interrupteur 9 intégrés dans le disjoncteur 6.

Le compteur 1 comporte de plus un conducteur de phase 10, qui est relié à la phase 4 du réseau de distribution 3 via le port de phase amont P, et qui est relié au disjoncteur 6 via le port de phase aval P'. Le compteur 1 comporte de plus un conducteur de neutre 11, qui est relié au neutre 5 via le port de neutre amont N, et qui est relié au disjoncteur 6 via le port de neutre aval N'.

Le compteur 1 comprend de plus un organe de coupure 12 comprenant un interrupteur 13 monté sur le conducteur de phase 10.

Le compteur 1 comprend une masse électrique 14. Le conducteur de phase 10 est relié à la masse 14 à proximité du port de phase amont P et en amont de l'organe de coupure 12. Cette mise à la masse du conducteur de phase 10 s'explique par le fait que le compteur 1 comporte un capteur de courant, permettant de mesurer le courant de phase circulant sur la phase 4, qui est un *shunt* (non représenté ici), positionné sur le conducteur de phase 10 en amont de l'organe de coupure 12. Sans mise à la masse du conducteur de phase 10, la tension aux bornes du *shunt* serait de l'ordre de celle présente entre la phase et le neutre du réseau 3, et donc très élevée. La mise à la masse du conducteur de phase 10 permet d'obtenir une tension faible aux bornes du *shunt* (ici de l'ordre de 3,3V maximum après l'application d'un gain sachant que la tension aux bornes d'un *shunt* est de l'ordre de 15 à 20mV pour un courant le traversant de 100A efficace), qui correspond à la plage de tension acceptable en entrée du microcontrôleur de métrologie (non représenté ici) intégré dans le compteur 1.

Le compteur 1 comporte de plus un circuit de détection.

Le circuit de détection comprend une chaîne d'injection 15, une chaîne de mesure 16, et un composant de traitement.

Ici, par « chaîne », on entend une succession d'un ou de plusieurs composants (ou modules fonctionnels) connectés en série.

La chaîne d'injection 15 comprend au moins un composant générateur (en l'occurrence ici deux composants générateurs), une résistance R, et un composant d'injection (en l'occurrence ici un premier condensateur C1).

Les deux composants générateurs comprennent un module générateur 20, intégré dans le microcontrôleur applicatif 17 du compteur 1, et un *driver* 21.

Le microcontrôleur 17 comprend une sortie PWM 22 (pour *Pulse Width Modulation*). La sortie du module générateur 20 est reliée à la sortie PWM 22.

Le *driver* 21 est ici un amplificateur monté en suiveur. La sortie 22 du microcontrôleur 17 est reliée à l'entrée non inverseuse du driver 21. L'entrée inverseuse du driver 21 est reliée à la sortie du *driver* 21.

La sortie du *driver* 21 est reliée à une première borne de la résistance R, dont une deuxième borne est reliée à une première borne du premier condensateur C1. La deuxième borne du premier condensateur C1 est connectée au conducteur de phase 10 en aval de l'organe de coupure 12.

La résistance R a une valeur de résistance qui est ici égale à 1kΩ.

Le premier condensateur C1 a une valeur de capacité qui est ici égale à 47nF. Le premier condensateur C1 est intégré dans un premier filtre passe-haut (filtre R-C1) permettant de filtrer des signaux parasites provenant du réseau de distribution 3.

La chaîne de mesure 16 comprend les éléments suivants, disposés successivement d'amont en aval : un deuxième filtre passe-haut 24, un convertisseur analogique-numérique (CAN) 25, un détecteur d'enveloppe 26 et un filtre passe-bas 27.

Ici, lorsque l'on parle de la position relative des différents éléments dans la chaîne de mesure 16, on entend :

- par « en amont » : du côté de la grandeur mesurée ;
- par « en aval » : du côté du traitement de la mesure.

Le deuxième filtre passe-haut 24 est donc ici un filtre analogique alors que le détecteur d'enveloppe 26 et le filtre passe-bas 27 sont des modules numériques.

Le CAN 25, le détecteur d'enveloppe 26 et le filtre passe-bas 27 sont ici intégrés dans le microcontrôleur 17.

Le composant de traitement du circuit de détection est ici le microcontrôleur 17.

Le microcontrôleur 17 est adapté à exécuter des instructions d'un programme pour mettre en oeuvre le procédé de détection qui va être décrit. Le programme est stocké dans une mémoire 28, qui est intégrée dans ou reliée au microcontrôleur 17.

Le compteur 1 comprend en outre un deuxième condensateur C2 positionné en amont de l'organe de coupure 12 et ayant une première borne connectée au conducteur de neutre 11 et une deuxième borne connectée au conducteur de phase 10. Le deuxième condensateur C2 a une valeur de capacité typiquement égale à celle du premier condensateur C1, c'est-à-dire ici à 47nF. Le deuxième condensateur C2, ainsi positionné entre le conducteur de neutre 11 et le conducteur de phase 10, permet de constituer un chemin de retour de masse maîtrisé pour les mesures réalisées pendant la détection (on rappelle que l'organe de coupure 12 est ouvert lors de la détection).

On décrit maintenant en détail la manière dont l'invention fonctionne.

Lorsque l'organe de coupure 12 est ouvert, un signal de test St est injecté périodiquement et pendant une durée prédéterminée par la chaîne d'injection 15. La période est par exemple égale à 1s et la durée prédéterminée à 500ms, c'est-à-dire que, lorsque l'organe de coupure 12 est ouvert, le signal de test St est injecté pendant 500ms et ce, toutes les 1s.

Alternativement, la chaîne d'injection 15 pourrait, lorsque l'organe de coupure 12 est ouvert, injecter le signal de test St en continu.

Pour réaliser cette injection, le module générateur 20 du microcontrôleur 17 produit le signal de test St et l'applique sur la sortie 22.

Le signal de test St est ici un signal alternatif carré (ou rectangulaire) ayant une fréquence avantageusement au moins cent fois supérieure à la fréquence du courant de phase circulant sur la phase 4 du réseau de distribution 3.

Ici, la fréquence du courant de phase est égale à 50Hz, et la fréquence du signal de test St est égale à 10kHz.

Le signal de test St est généré par le microcontrôleur 17 avec un niveau de tension prédéterminé, ici égal à 3,3V (crête à crête).

Le signal de test St est appliqué sur l'entrée non inverseuse du *driver* 21 et est donc reproduit sur la sortie du *driver* 21.

Le *driver* 21 forme une source de courant fournissant un courant complémentaire permettant d'assurer que le signal de test St est généré avec un niveau de courant suffisant pour conserver, en sortie des composants générateurs (c'est-à-dire ici en sortie du *driver* 21), un niveau de tension égal au niveau de tension prédéterminé. Le *driver* 21 est ici nécessaire, car les différents éléments constituant et reliés à la chaîne d'injection 15 « tirent » du courant que n'est pas capable de fournir seul le microcontrôleur 17.

La résistance R permet de limiter le courant.

Le premier condensateur C1 permet d'injecter le signal de test St, produit par le microcontrôleur 17 et le *driver* 21, sur le conducteur de phase 10 en aval de l'organe de coupure 12.

La chaîne de mesure 16 permet de mesurer, en un point de mesure Pm de la chaîne d'injection 15 situé entre le au moins un composant générateur et le composant d'injection, un niveau de tension intermédiaire du signal de test St.

Le point de mesure Pm est ici situé entre la résistance R et le premier condensateur C1.

Le deuxième filtre passe-haut 24 est ici un filtre passe-haut actif de gain égal à 1. La fréquence de coupure du deuxième filtre passe-haut 24 est typiquement égale à 5kHz. Le deuxième filtre passe-haut 24, situé en amont du CAN 25, permet d'éliminer le 50Hz éventuel (qui peut être capté par effet d'antenne dans le cas où l'organe de coupure 12 et le disjoncteur 6 sont tous les 2 ouverts) et les éventuelles perturbations venant du réseau 3. Le deuxième filtre passe-haut 24 permet donc de présenter au CAN 25 un signal non perturbé. Il suffit alors de détecter l'enveloppe de ce signal (via le détecteur d'enveloppe numérique 26) et de filtrer en numérique la sortie du détecteur 26 par le filtre passe-bas 27, dont la fréquence de coupure est typiquement égale à 10Hz.

Le microcontrôleur 17 compare le niveau de tension intermédiaire mesuré du signal de test St avec un seuil prédéterminé, et détecte que le disjoncteur 6 est ouvert lorsque le niveau de tension intermédiaire du signal de test St est supérieur au seuil prédéterminé, et que le disjoncteur 6 est fermé lorsque le niveau de tension intermédiaire du signal de test St est inférieur ou égal au seuil prédéterminé.

En effet, lorsque le disjoncteur 6 est ouvert, le signal entrant vers le CAN 25 est élevé.

On suppose ici que le module de la charge Z(abonné) et la charge Z(amont) sont très faibles devant la résistance R à 10kHz (mais cela n'est pas systématique, du moins en ce qui concerne Z(abonné) : voir plus bas).

Après filtrage passe-bas, le niveau de tension intermédiaire mesuré est égal à un niveau haut Vh égal à 3,3V (c'est-à-dire au niveau de tension prédéterminé Vp du signal de test St).

Par contre, lorsque le disjoncteur 6 est fermé, le signal entrant vers le CAN 25 est sensiblement plus faible. Après filtrage passe-bas, le niveau de tension intermédiaire mesuré est égal à un niveau bas Vb, qui est égal à (division de tension) :

```
Vb=Vp*(Z(C1)+Z(abonné)+Z(C2)//Z(amont))/(R+Z(C1)+Z(abo
nné)+ Z(C2)//Z(amont)),
```

où :

Z(C1) est une impédance du premier condensateur, Z(C2) est une impédance du deuxième condensateur, Z(amont) est une impédance entre la phase et le neutre en amont du compteur 1, Z(abonné) est une impédance entre la phase et le neutre en aval du compteur 1, lesdites impédances étant estimées à une fréquence du signal de test (c'est-à-dire à 10kHz).

Le seuil prédéterminé Sp est donc compris entre le niveau haut Vh (égal ici au niveau de tension prédéterminé Vp) et le niveau bas Vb.

Le niveau bas est ici égal à 1,06V.

Le seuil prédéterminé Sp « idéal », et utilisé ici, est donc tel que :

```
Sp = (Vh+Vb)/2 = 2,18V.
```

On note que, par défaut, la sortie PWM 22 est à 0, de sorte qu'aucune injection du signal de test St n'est appliquée au niveau du point de mesure. C'est également toujours le cas lorsque l'organe de coupure 12 est fermé.

En référence à la figure 2, le compteur 101 selon un deuxième mode de réalisation est un compteur triphasé. Chaque élément représenté sur la figure 2, qui est semblable à un élément de la figure 1, est référencé en ajoutant 100 à la référence de la figure 1.

Le réseau de distribution 103 comprend trois phases 104_i (i variant de 1 à 3) et un neutre 105.

Pour chaque phase 104_i, le compteur 101 comprend un port de phase amont Pi relié à ladite phase 104_i, et un port de phase aval P'i.

Le compteur 101 comprend de plus un port de neutre amont N relié au neutre 105 et un port de neutre aval N'.

Les ports de phase aval P'i et le port de neutre aval N' du compteur 101 sont reliés à l'installation 102, respectivement via des interrupteurs 108_i et un interrupteur 109 intégrés dans le disjoncteur 106.

Le compteur 101 comporte de plus, pour chaque phase 104_i, un conducteur de phase 110_i relié à ladite phase 104_i via le port de phase amont Pi associé. Le compteur 101 comporte de plus un conducteur de neutre 111 relié au neutre 105 via le port de neutre amont N.

Le compteur 101 comprend de plus un organe de coupure 112 comprenant, pour chaque phase, un interrupteur 113_i monté sur le conducteur de phase 110_i associé.

Le compteur 101 comprend de plus un circuit de détection permettant de détecter, lorsque l'organe de coupure 112 est ouvert, si le disjoncteur 106 est ouvert ou fermé.

On sait que les quatre interrupteurs 108_i, 109 du disjoncteurs 106, tout comme les trois interrupteurs 113_i de l'organe de coupure 112, sont soit tous ouverts en même temps, soit tous fermés en même temps.

Par conséquent, le compteur 101 n'intègre ici qu'un seul circuit de détection, connecté à un seul conducteur de phase 110_i (reliée à la phase 104_i représentée sur la figure 2). Le compteur 101 pourrait cependant parfaitement intégrer plusieurs circuits de détection pour confirmer le résultat et ainsi améliorer la robustesse de la détection.

Le circuit de détection du compteur 101 fonctionne de la même manière que le circuit de détection du compteur 1.

Le circuit de détection comporte une chaîne d'injection 115 qui comprend le module générateur 120 intégré dans le microcontrôleur applicatif 117 et le *driver* 121 (les deux composants générateurs), un premier condensateur C1 (le composant d'injection), et une résistance R montée entre la sortie du *driver* 121 et le premier condensateur C1. Le premier condensateur C1 et la résistance R forment un premier filtre passe-haut.

Le circuit de détection comprend aussi une chaîne de mesure 116 comprenant un deuxième filtre passe-haut 124 (analogique), un CAN 125, un détecteur d'enveloppe 126 (numérique) et un filtre passe-bas 127 (numérique).

Le circuit de détection comprend de plus un composant de traitement, en l'occurrence le microcontrôleur 117 (dans lequel sont intégrés le CAN 125, le détecteur d'enveloppe 126 et le filtre passe-bas 127).

On note que, dans le cas du compteur triphasé 101, pour chaque phase 104_i, le capteur de courant utilisé pour mesurer le courant de phase circulant sur ladite phase 104_i est un tore et non un *shunt*. Le conducteur de neutre 105 peut donc être mis à la masse (masse électrique 114) qui est visible par le microcontrôleur 117, de sorte que le deuxième condensateur C2 n'est pas nécessaire.

Lorsque l'organe de coupure 112 est ouvert, le signal de test St est généré et injecté de la même manière que pour le circuit de détection précédemment décrit.

On suppose à nouveau que le module de la charge Z(abonné) est très faible devant la résistance R à 10kHz.

Lorsque le disjoncteur 106 est ouvert, le niveau de tension intermédiaire mesuré est égal à un niveau haut Vh égal à 3,3V (c'est-à-dire au niveau de tension prédéterminé Vp du signal de test St).

Lorsque le disjoncteur 106 est fermé, le niveau de tension intermédiaire mesuré est sensiblement plus faible. Après filtrage passe-bas, le niveau de tension intermédiaire mesuré est égal à un niveau bas Vb, qui est égal à :

$$Vb=Vp*(Z(C1)+Z(abonné))/(R+Z(C1)+Z(abonné))$$

où :

Z(C1) est une impédance du premier condensateur, Z(abonné) est une impédance entre la phase et le neutre en aval du compteur, lesdites impédances étant estimées à une fréquence du signal de test (ici 10kHz).

Le seuil prédéterminé Sp est donc compris entre le niveau haut Vh et le niveau bas Vb.

Le niveau bas Vb est ici égal à 1,06V.

Le seuil prédéterminé Sp « idéal », et utilisé ici, est donc tel que :

$$Sp = (Vh+Vb)/2 = 2,18V.$$

On note ici que, aussi bien dans le cas du compteur monophasé 1 que du compteur triphasé 101, on a considéré que le module de la charge Z(abonné) est très faible devant la résistance R (à 10kHz).

Or, cette configuration « standard » n'est pas systématique.

L'impédance Z(abonné) peut ne pas être négligeable devant la résistance R, voire même être sensiblement supérieure à R (l'impédance Z(amont), quant à elle, étant inférieure ou égale à 2Ω, reste systématiquement négligeable devant R).

Cela se produit par exemple en Espagne, où le pire cas correspond au cas où le disjoncteur 6 (respectivement 106) est éloigné géographiquement du compteur 1 (respectivement 101).

Dans ce cas, lorsque le disjoncteur est ouvert, le câble entre le compteur et le disjoncteur ramène aux bornes du compteur une impédance équivalente, qui dépend de la longueur et de la nature du câble, et qui peut aller jusqu'à 1200kΩ.

Lorsque le disjoncteur est fermé, en plus de ces 1200kΩ, on a en parallèle une impédance Z(abonné) pouvant atteindre 210kΩ.

Dans cette configuration « de type Espagne », afin d'améliorer la différence entre le niveau de tension intermédiaire mesuré au point Pm lorsque le disjoncteur est ouvert (niveau haut Vh) et lorsque le disjoncteur est fermé (niveau bas Vb), on modifie la valeur de R et de C1 (C2 reste inchangée à 47nF).

On choisit par exemple R = 22kΩ et C1 = 2,2nF.

Ainsi, dans cette configuration « de type Espagne », on obtient les niveaux de tension intermédiaires suivants, que l'on soit en monophasé ou en triphasé (en utilisant les formules précédentes) :

- disjoncteur ouvert : Vh = 3,24V ;
- disjoncteur fermé : Vb = 2,94V,

  ce qui donne un seuil prédéterminé Sp « idéal » :

$$Sp = 3,09V.$$

Par ailleurs, ces « nouvelles » valeurs de R et de C1 sont tout à fait applicables à la configuration « standard » décrite précédemment (pas d'impédance ramenée de 1200kΩ et Z(abonné) << R).

Dans la configuration « standard », les calculs avec les nouvelles valeurs de composants donnent :

- disjoncteur ouvert : Vh = 3,3V ;
- disjoncteur fermé : Vb = 1,03V.

Le seuil prédéterminé Sp « idéal » est donc tel que :

$$Sp = 2,17V.$$

On note en outre qu'un seuil prédéterminé Sp égal à 3,09V, au lieu de 2,17V, est compatible à la fois avec la configuration « de type Espagne » et avec la configuration « standard ».

On note aussi que la fréquence de coupure à 3dB du filtre Passe-Haut R-C1 reste quasiment inchangée à 3% près, en utilisant les valeurs utilisées pour la configuration « standard » ou la configuration « de type Espagne », puisqu'elle passe de 3386Hz à 3288Hz.

Bien entendu, l'invention n'est pas limitée aux modes de réalisation décrits mais englobe toute variante entrant dans le champ de l'invention telle que définie par les revendications.

Le détecteur d'enveloppe, qui est ici réalisé en numérique, pourrait tout aussi bien être réalisé en analogique, et donc positionné en amont du CAN.

Les valeurs de capacité du premier condensateur C1 et du deuxième condensateur C2 pourraient être différentes de celles données ici. De même, la valeur de la résistance R pourrait être modifiée en l'augmentant typiquement.

La fréquence du signal de test pourrait être également modifiée, auquel cas il faudrait adapter le seuil de détection prédéterminé à schéma équivalent. Le seuil de détection prédéterminé pourrait être paramétrable.

Le *driver* n'est pas obligatoire. En particulier, si le module générateur qui génère le signal de test (ici le microcontrôleur applicatif) est capable de fournir suffisamment de courant, le *driver* n'est pas nécessaire.

Le microcontrôleur dans lequel est mise en oeuvre l'invention n'est pas nécessairement le microcontrôleur applicatif mais pourrait être un composant distinct.

Le composant de traitement dans lequel est mise en oeuvre l'invention n'est pas nécessairement un microcontrôleur, mais pourrait être un composant différent, et par exemple un processeur classique, un DSP (pour *Digital Signal Processor,* que l'on peut traduire par « processeur de signal numérique »), ou bien un circuit logique programmable tel qu'un FPGA (pour *Field Programmable Gate Arrays*) ou un ASIC (pour *Application Spécifie Integrated Circuit).*

## Revendications

**1.** Compteur (1 ; 101) agencé pour mesurer une énergie électrique fournie à une installation (2 ; 102) par un réseau de distribution (3 ; 103) comprenant une phase et un neutre, le compteur étant agencé pour être connecté à un disjoncteur (6 ; 106) situé à l'extérieur et en aval du compteur, le compteur comportant :

- un conducteur de phase (10 ; 110_i) et un conducteur de neutre (11 ; 111) agencés pour être reliés respectivement à la phase et au neutre du réseau de distribution ;
- un organe de coupure (12 ; 112) monté sur le conducteur de phase ;
- un circuit de détection comportant :

○ une chaîne d'injection (15 ; 115) comprenant au moins un composant générateur et un composant d'injection, le au moins un composant générateur étant agencé pour, lorsque l'organe de coupure est ouvert, générer un signal de test (St) avec un niveau de tension prédéterminé, le composant d'injection étant agencé pour injecter le signal de test sur le conducteur de phase en aval de l'organe de coupure ;
○ une chaîne de mesure (16 ; 116) agencée pour mesurer, en un point de mesure (Pm) de la chaîne d'injection situé entre le au moins un composant générateur et le composant d'injection, un niveau de tension intermédiaire du signal de test ;
○ un composant de traitement (17 ; 117) agencé pour déterminer, en fonction du niveau de tension intermédiaire, si le disjoncteur est ouvert ou fermé.

2. Compteur selon la revendication 1, le composant d'injection étant un premier condensateur (C1) intégré dans un premier filtre passe-haut permettant de filtrer des signaux parasites provenant du réseau de distribution.

3. Compteur selon l'une des revendications précédentes, dans lequel le au moins un composant générateur comporte un module générateur (20 ; 120) agencé pour produire le signal de test avec le niveau de tension prédéterminé, et un *driver* (21 ; 121) formant une source de courant agencée pour assurer que le signal de test est généré avec un niveau de courant suffisant pour conserver, en sortie du au moins un composant générateur, un niveau de tension égal au niveau de tension prédéterminé.

4. Compteur selon l'une des revendications précédentes, dans lequel la chaîne de mesure comporte successivement, d'amont en aval, un deuxième filtre passe-haut (24 ; 124), un détecteur d'enveloppe (26 ; 126) et un filtre passe-bas (27 ; 127) .

5. Compteur selon la revendication 4, comprenant en outre un convertisseur analogique numérique (25 ; 125) positionné en amont du détecteur d'enveloppe.

6. Compteur selon la revendication 4, comprenant en outre un convertisseur analogique numérique positionné en aval du détecteur d'enveloppe.

7. Compteur selon l'une des revendications précédentes, la chaîne d'injection étant agencée pour, lorsque l'organe de coupure est ouvert, injecter le signal de test périodiquement, pendant une durée prédéterminée.

8. Compteur selon l'une des revendications 1 à 6, la chaîne d'injection étant agencée pour, lorsque l'organe de coupure est ouvert, injecter le signal de test en continu.

9. Compteur selon l'une des revendications précédentes, dans lequel le signal de test est un signal alternatif ayant une fréquence au moins cent fois supérieure à une fréquence d'un courant de phase circulant sur la phase du réseau de distribution.

10. Compteur selon l'une des revendications précédentes, le compteur étant un compteur monophasé (1).

11. Compteur selon la revendication 10, dans lequel le conducteur de phase est relié à une masse électrique (14) du compteur en amont de l'organe de coupure, le compteur comprenant en outre un deuxième condensateur (C2) positionné en amont de l'organe de coupure et ayant une première borne connectée au conducteur de neutre et une deuxième borne connectée au conducteur de phase.

12. Compteur selon la revendication 11, le composant d'injection étant un premier condensateur (C1), la chaîne d'injection comprenant une résistance (R) montée entre le premier condensateur et une sortie du au moins un composant générateur, le composant de traitement étant agencé pour comparer le niveau de tension intermédiaire du signal de test avec un seuil de détection prédéterminé, et pour détecter que le disjoncteur est ouvert lorsque le niveau de tension intermédiaire du signal de test est supérieur au seuil de détection prédéterminé, et que le disjoncteur est fermé lorsque le niveau de tension intermédiaire du signal de test est inférieur ou égal au seuil de détection prédéterminé, le seuil de détection prédéterminé étant compris entre un niveau haut et un niveau bas Vb tel que :

$$Vb=Vp*(Z(C1)+Z(abonné)+Z(C2)//Z(amont))/(R+Z(C1)+Z(abonné)+$$
$$Z(C2)//Z(amont)),$$

où :
Vp est le niveau de tension prédéterminé, Z (C1) est une impédance du premier condensateur, Z(C2) est une impédance du deuxième condensateur, Z(amont) est une impédance entre la phase et le neutre en amont du compteur, Z(abonné) est une impédance entre la phase et le neutre en aval du compteur, lesdites impédances étant estimées à une fréquence du signal de test.

13. Compteur selon l'une des revendications 1 à 9, le compteur étant un compteur triphasé (101).

14. Compteur selon la revendication 13, le composant d'injection étant un premier condensateur (C1), la chaîne d'injection comprenant une résistance (R) montée entre le premier condensateur et une sortie du au moins un composant générateur, le composant de traitement étant agencé pour comparer le niveau de tension intermédiaire du signal de test avec un seuil de détection prédéterminé, et pour détecter que le disjoncteur est ouvert lorsque le niveau de tension intermédiaire du signal de test est supérieur au seuil de détection prédéterminé, et que le disjoncteur est fermé lorsque le niveau de tension intermédiaire du signal de test est inférieur ou égal au seuil de détection prédéterminé, le seuil de détection prédéterminé étant compris entre un niveau haut et un niveau bas Vb tel que :

$$Vb=Vp*(Z(C1)+Z(abonné))/(R+Z(C1)+Z(abonné))$$

où :
Vp est le niveau de tension prédéterminé du signal de test, Z(C1) est une impédance du premier condensateur, Z(abonné) est une impédance entre la phase et le neutre en aval du compteur, lesdites impédances étant estimées à une fréquence du signal de test.

15. Procédé de détection, mis en oeuvre dans le composant de traitement (17 ; 117) d'un compteur selon l'une des revendications précédentes, et comprenant les étapes, lorsque l'organe de coupure est ouvert, de :

- faire générer et injecter, par la chaîne d'injection, le signal de test sur le conducteur de phase en aval de l'organe de coupure ;
- acquérir le niveau de tension intermédiaire du signal de test ;
- déterminer, en fonction du niveau de tension intermédiaire du signal de test, si le disjoncteur est ouvert ou fermé.

16. Programme d'ordinateur comprenant des instructions qui conduisent le composant de traitement du compteur selon l'une des revendications 1 à 14 à exécuter les étapes du procédé de détection selon la revendication 15.

17. Support d'enregistrement lisible par ordinateur, sur lequel est enregistré le programme d'ordinateur selon la revendication 16.

**Patentansprüche**

1. Zähler (1; 101), der ausgebildet ist, eine elektrische Energie zu messen, die von einem Verteilungsnetz (3; 103), das eine Phasenleitung und eine Neutralleitung umfasst, an eine Anlage (2; 102) geliefert wird, wobei der Zähler ausgebildet ist, mit einem Schutzschalter (6; 106) verbunden zu werden, der sich außerhalb und stromabwärts des Zählers befindet, wobei der Zähler umfasst:

- einen Phasenleiter (10; 110_i) und einen Neutralleiter (11; 111), die ausgebildet sind, mit der Phasenleitung bzw. der Neutralleitung des Verteilungsnetzes verbunden zu werden;
- ein Trennorgan (12; 112), das auf dem Phasenleiter angebracht ist;
- einen Detektionskreis, der umfasst:

◦ eine Injektionskette (15; 115), die mindestens eine Erzeugerkomponente und eine Injektionskomponente umfasst, wobei die mindestens eine Erzeugerkomponente ausgebildet ist, um, wenn das Trennorgan offen ist, ein Testsignal (St) mit einem vorbestimmten Spannungsniveau zu erzeugen, wobei die Injektionskomponente ausgebildet ist, das Testsignal auf den Phasenleiter stromabwärts des Trennorgans zu injizieren;

◦ eine Messkette (16; 116), die ausgebildet ist, an einem Messpunkt (Pm) der Injektionskette, der sich zwischen der mindestens einen Erzeugerkomponente und der Injektionskomponente befindet, ein intermediäres Spannungsniveau des Testsignals zu messen;

◦ eine Verarbeitungskomponente (17; 117), die ausgebildet ist, in Abhängigkeit von dem intermediären Spannungsniveau zu bestimmen, ob der Schutzschalter offen oder geschlossen ist.

2.  Zähler nach Anspruch 1, wobei die Injektionskomponente ein erster Kondensator (C1) ist, der in ein erstes Hochpassfilter integriert ist, das ermöglicht, Störsignale, die aus dem Verteilungsnetz stammen, zu filtern.

3.  Zähler nach einem der vorhergehenden Ansprüche, bei dem die mindestens eine Erzeugerkomponente ein Erzeugermodul (20; 120) umfasst, das ausgebildet ist, das Testsignal mit dem vorbestimmten Spannungsniveau zu erzeugen, und einen Treiber (21; 121), der eine Stromquelle bildet, die ausgebildet ist, sicherzustellen, dass das Testsignal mit einem ausreichenden Stromniveau erzeugt wird, um am Ausgang der mindestens einen Erzeugerkomponente ein Spannungsniveau beizubehalten, das gleich dem vorbestimmten Spannungsniveau ist.

4.  Zähler nach einem der vorhergehenden Ansprüche, bei dem die Messkette nacheinander, von stromaufwärts nach stromabwärts, ein zweites Hochpassfilter (24; 124), einen Hülldetektor (26; 126) und ein Tiefpassfilter (27; 127) umfasst.

5.  Zähler nach Anspruch 4, ferner umfassend einen Analog-Digital-Wandler (25; 125), der stromaufwärts des Hülldetektors positioniert ist.

6.  Zähler nach Anspruch 4, ferner umfassend einen Analog-Digital-Wandler, der stromabwärts des Hülldetektors positioniert ist.

7.  Zähler nach einem der vorhergehenden Ansprüche, wobei die Injektionskette ausgebildet ist, um, wenn das Trennorgan offen ist, das Testsignal periodisch über eine vorbestimmte Dauer zu injizieren.

8.  Zähler nach einem der Ansprüche 1 bis 6, wobei die Injektionskette ausgebildet ist, um, wenn das Trennorgan offen ist, das Testsignal kontinuierlich zu injizieren.

9.  Zähler nach einem der vorhergehenden Ansprüche, bei dem das Testsignal ein Wechselsignal ist, das eine Frequenz hat, die mindestens hundert Mal größer als eine Frequenz eines Phasenstroms ist, der auf der Phasenleitung des Verteilungsnetzes fließt.

10. Zähler nach einem der vorhergehenden Ansprüche, wobei der Zähler ein Einphasenzähler (1) ist.

11. Zähler nach Anspruch 10, bei dem der Phasenleiter mit einer elektrischen Masse (14) des Zählers stromaufwärts des Trennorgans verbunden ist, wobei der Zähler ferner einen zweiten Kondensator (C2) umfasst, der stromaufwärts des Trennorgans positioniert ist und eine erste Klemme hat, die mit dem Neutralleiter verbunden ist, und eine zweite Klemme, die mit dem Phasenleiter verbunden ist.

12. Zähler nach Anspruch 11, wobei die Injektionskomponente ein erster Kondensator (C1) ist, wobei die Injektionskette einen Widerstand (R) umfasst, der zwischen den ersten Kondensator und einen Ausgang der mindestens einen Erzeugerkomponente geschaltet ist, wobei die Verarbeitungskomponente ausgebildet ist, das intermediäre Spannungsniveau des Testsignals mit einem vorbestimmten Detektionsschwellenwert zu vergleichen und zu detektieren, dass der Schutzschalter offen ist, wenn das intermediäre Spannungsniveau des Testsignals höher als der vorbestimmte Detektionsschwellenwert ist, und dass der Schutzschalter geschlossen ist, wenn das intermediäre Spannungsniveau des Testsignals niedriger oder gleich dem vorbestimmten Detektionsschwellenwert ist, wobei der vorbestimmte Detektionsschwellenwert zwischen einem oberen Niveau und einem unteren Niveau Vb liegt, sodass:

$$Vb=Vp*(Z(C1)+Z(abonné)+Z(C2)//Z(amont))/(R+Z(C1)+Z(abonné)$$

$$+Z(C2)//Z(amont)),$$

wobei
Vp das vorbestimmte Spannungsniveau ist, $Z(C1)$ eine Impedanz des ersten Kondensators ist, $Z(C2)$ eine Impedanz des zweiten Kondensators ist, $Z(amont)$ eine Impedanz zwischen der Phasenleitung und der Neutralleitung stromaufwärts des Zählers ist, $Z(abonné)$ eine Impedanz zwischen der Phasenleitung und der Neutralleitung stromabwärts des Zählers ist, wobei die genannten Impedanzen bei einer Frequenz des Testsignals geschätzt werden.

13. Zähler nach einem der Ansprüche 1 bis 9, wobei der Zähler ein Dreiphasenzähler (101) ist.

14. Zähler nach Anspruch 13, wobei die Injektionskomponente ein erster Kondensator (C1) ist, wobei die Injektionskette einen Widerstand (R) umfasst, der zwischen den ersten Kondensator und einen Ausgang der mindestens einen Erzeugerkomponente geschaltet ist, wobei die Verarbeitungskomponente ausgebildet ist, das intermediäre Spannungsniveau des Testsignals mit einem vorbestimmten Detektionsschwellenwert zu vergleichen und zu detektieren, dass der Schutzschalter offen ist, wenn das intermediäre Spannungsniveau des Testsignals höher als der vorbestimmte Detektionsschwellenwert ist, und dass der Schutzschalter geschlossen ist, wenn das intermediäre Spannungsniveau des Testsignals niedriger oder gleich dem vorbestimmten Detektionsschwellenwert ist, wobei der vorbestimmte Detektionsschwellenwert zwischen einem oberen Niveau und einem unteren Niveau Vb liegt, sodass:

$$Vb=Vp*(Z(C1)+Z(abonné))/(R+Z(C1)+Z(abonné)),$$

wobei
Vp das vorbestimmte Spannungsniveau des Testsignals ist, $Z(C1)$ eine Impedanz des ersten Kondensators ist, $Z(abonné)$ eine Impedanz zwischen der Phasenleitung und der Neutralleitung stromabwärts des Zählers ist, wobei die genannten Impedanzen bei einer Frequenz des Testsignals geschätzt werden.

15. Detektionsverfahren, das in der Verarbeitungskomponente (17; 117) eines Zählers nach einem der vorhergehenden Ansprüche durchgeführt wird und die Schritte umfasst, wenn das Trennorgan offen ist:

- Erzeugen und Injizieren des Testsignals auf den Phasenleiter stromabwärts des Trennorgans durch die Injektionskette;
- Erfassen des intermediären Spannungsniveaus des Testsignals;
- Bestimmen in Abhängigkeit des intermediären Spannungsniveaus des Testsignals, ob der Schutzschalter offen oder geschlossen ist.

16. Computerprogramm, umfassend Anweisungen, die die Verarbeitungskomponente des Zählers nach einem der Ansprüche 1 bis 14 veranlassen, die Schritte des Detektionsverfahrens nach Anspruch 15 auszuführen.

17. Computerlesbarer Aufzeichnungsträger, auf dem das Computerprogramm nach Anspruch 16 gespeichert ist.

**Claims**

1. A meter (1; 101) arranged to measure electrical energy delivered to an installation (2; 102) by a distribution network (3; 103) comprising a phase line and a neutral line, the meter being arranged to be connected to a circuit breaker (6; 106) situated outside the meter and downstream therefrom, the meter comprising:

· a phase conductor (10; 110_i) and a neutral conductor (11; 111) arranged to be connected respectively to the phase line and to the neutral line of the distribution network;
· a cut-off member (12; 112) connected in the phase conductor;
· a detection circuit comprising:

∘ an injection chain (15; 115) comprising at least one generator component and an injection component, the at least one generator component being arranged, while the cut-off member is open, to generate a test signal (St) with a predetermined voltage level, the injection component being arranged to inject the test signal into the phase conductor downstream from the cut-off member;

◦ a measurement chain (16; 116) arranged to measure an intermediate voltage level of the test signal at a measurement point (Pm) of the injection chain, which point is situated between the at least one generator component and the injection component;

◦ a processor component (17; 117) arranged to act as a function of the intermediate voltage level in order to determine whether the circuit breaker is open or closed.

2. A meter according to claim 1, the injection component being a first capacitor (C1) that is integrated in a first highpass filter serving to filter out interfering signals coming from the distribution network.

3. A meter according to either preceding claim, wherein the at least one generator component comprises both a generator module (20; 120) arranged to produce the test signal with the predetermined voltage level and also a driver (21; 121) forming a current source arranged to ensure that the test signal is generated with a current level that is sufficient for conserving a voltage level at the output of the at least one generator component that is equal to the predetermined voltage level.

4. A meter according to any preceding claim, wherein the measurement chain comprises in succession, from upstream to downstream, a second highpass filter (24; 124), an envelope detector (26; 126), and a lowpass filter (27; 127) .

5. A meter according to claim 4, further comprising an analog-to-digital converter (25; 125) positioned upstream from the envelope detector.

6. A meter according to claim 4, further comprising an analog-to-digital converter positioned downstream from the envelope detector.

7. A meter according to any preceding claim, the injection chain being arranged, while the cut-off member is open, to inject the test signal periodically for a predetermined duration.

8. A meter according to any one of claims 1 to 6, the injection chain being arranged, while the cut-off member is open, to inject the test signal continuously.

9. A meter according to any preceding claim, wherein the test signal is an alternating signal at a frequency that is at least one hundred times greater than the frequency of the phase current flowing in the phase line of the distribution network.

10. A meter according to any preceding claim, the meter being a single-phase meter (1).

11. A meter according to claim 10, wherein the phase conductor is connected to electrical ground (14) of the meter upstream from the cut-off member, the meter further comprising a second capacitor (C2) positioned upstream from the cut-off member and having a first terminal connected to the neutral conductor and a second terminal connected to the phase conductor.

12. A meter according to claim 11, the injection component being a first capacitor (C1), the injection chain comprising a resistor (R) connected between the first capacitor and an output of the at least one generator component, the processor component being arranged to compare the intermediate voltage level of the test signal with a predetermined detection threshold, and to detect that the circuit breaker is open when the intermediate voltage level of the test signal is greater than the predetermined threshold and that the circuit breaker is closed when the intermediate voltage level of the test signal is less than or equal to the predetermined detection threshold, the predetermined detection threshold lying between a high level and a low level Vb such that:

$$Vb=Vp*(Z(C1)+Z(subscriber)+Z(C2)||Z(upstream))/(R+Z(C1)+Z(subscriber)+ Z(C2)||Z(upstream))$$

where:

Vp is the predetermined voltage level, Z(C1) is the impedance of the first capacitor, Z(C2) is the impedance of the second capacitor, Z(upstream) is the impedance between the phase line and the neutral line upstream from the

EP 4 184 183 B1

meter, and Z(subscriber) is the impedance between the phase line and the neutral line downstream from the meter, said impedances being estimated at the frequency of the test signal.

13. A meter according to any one of claims 1 to 9, the meter being a three-phase meter (101).

14. A meter according to claim 13, the injection component being a first capacitor (C1), the injection chain including a resistor (R) connected between the first capacitor and an output of the at least one generator component, the processor component being arranged to compare the intermediate voltage level of the test signal with a predetermined detection threshold, and to detect that the circuit breaker is open when the intermediate voltage level of the test signal is greater than the predetermined threshold and that the circuit breaker is closed when the intermediate voltage level of the test signal is less than or equal to the predetermined detection threshold, the predetermined detection threshold lying between a high level and a low level Vb such that:

$$Vb=Vp*(Z(C1)+Z(subscriber))/(R+Z(C1)+Z(subscriber))$$

where:

Vp is the predetermined voltage level of the test signal,
Z(C1) is the impedance of the first capacitor, and
Z(subscriber) is the impedance between the phase line and the neutral line downstream from the meter, said impedances being estimated at the frequency of the test signal.

15. A detection method performed in the processor component (17; 117) of a meter according to any preceding claim, the method comprising the following steps performed while the cut-off member is open:

· using the injection chain to generate and inject the test signal into the phase conductor downstream from the cut-off member;
· acquiring the intermediate voltage level of the test signal;
· as a function of the intermediate voltage level of the test signal, determining whether the circuit breaker is open or closed.

16. A computer program including instructions that cause the processor component of the meter according to any one of claims 1 to 14 to execute the steps of the detection method according to claim 15.

17. A computer-readable storage medium storing the computer program according to claim 16.

14

Fig. 1

Fig. 2

**EP 4 184 183 B1**

## RÉFÉRENCES CITÉES DANS LA DESCRIPTION

**Documents brevets cités dans la description**

- US 2020309856 A1
- US 8610424 B2